# EUROPÄISCHE PATENTSCHRIFT

(11) **EP 0 446 571 B1**
(45) Veröffentlichungstag und Bekanntmachung des Hinweises auf die Patenterteilung: **03.05.1995**
(21) Anmeldenummer: 91100299.6
(22) Anmeldetag: 11.01.1991
(51) Int. Cl.: H03L 7/10

(54) **Einschleifen-PLL-Schaltung**
Single loop PLL circuit
Circuit PLL à boucle unique

(30) Priorität: 15.03.1990 DE 4008245
(43) Veröffentlichungstag der Anmeldung: 18.09.1991
(73) Patentinhaber: ROBERT BOSCH GMBH, 70442 Stuttgart (DE)
(72) Erfinder: Bitar, Omar, Dipl.-Ing., W-1000 Berlin 48 (DE)

(56) Entgegenhaltungen:
- GB-A- 2 143 385
- US-A- 3 906 375

## Beschreibung

Die Erfindung geht von einer Einschleifen-PLL-Schaltung nach dem Oberbegriff des Anspruchs 1 aus.

### Stand der Technik

Es ist eine Einschleifen-PLL-Schaltung bekannt, bei der zur Erzielung einer kurzen Einrastzeit die Frequenz des Schleifenfilters verhältnismäßig hoch gewählt werden muß. Daraus resultieren ein hoher Schleifenfilteraufwand und höhere Rauschwerte der PLL-Schaltung.

### Aufgabe

Der Erfindung liegt die Aufgabe zugrunde, eine Einschleifen-PLL-Schaltung gemäß dem Oberbegriff des Anspruchs 1 derart weiterzubilden, daß sich eine kurze Einrastzeit bei vergleichsweise niedriger Schleifenfrequenz ergibt, wobei der Schleifenfilteraufwand und die Rauschwerte der PLL-Schaltung gering sind.

### Lösung

Diese Aufgabe wird bei einer Einschleifen-PLL-Schaltung gemäß dem Oberbegriff des Anspruchs 1 durch die im kennzeichnenden Teil dieses Anspruchs angegebenen Merkmale gelöst. Die mit der Erfindung erzielbaren Vorteile bestehen insbesondere darin, daß sich bei einer Einschleifen-PLL-Schaltung eine bisher nicht erreichbare kurze Einrastzeit ergibt. Ein bevorzugtes Anwendungsgebiet für die erfindungsgemäße Einschleifen-PLL-Schaltung sind Funktelefone für das Netz D.

### Beschreibung

Ausführungsbeispiele der Erfindung sind in der Zeichnung an Hand mehrerer Figuren dargestellt und werden im folgenden näher erläutert. Es zeigen
- Fig. 1: ein Schaltbild einer erfindungsgemäßen Einschleifen-PLL-Schaltung,
- Fig. 2: den Kurvenverlauf der Eingangs- und Ausgangsspannungen an einer Phasenvergleichsschaltung der Einschleifen-PLL-Schaltung,
- Fig. 3: den Kurvenverlauf der Steuerspannung für den spannungsgesteuerten Oszillator der Einschleifen-PLL-Schaltung ohne Rückkopplungsschaltung,
- Fig. 4: den Kurvenverlauf der Steuerspannung mit Rückkopplungsschaltung und
- Fig. 5: den Kurvenverlauf der Steuerspannung bei Einschaltung eines Phasenschiebers am Ausgang des Trennverstärkers.

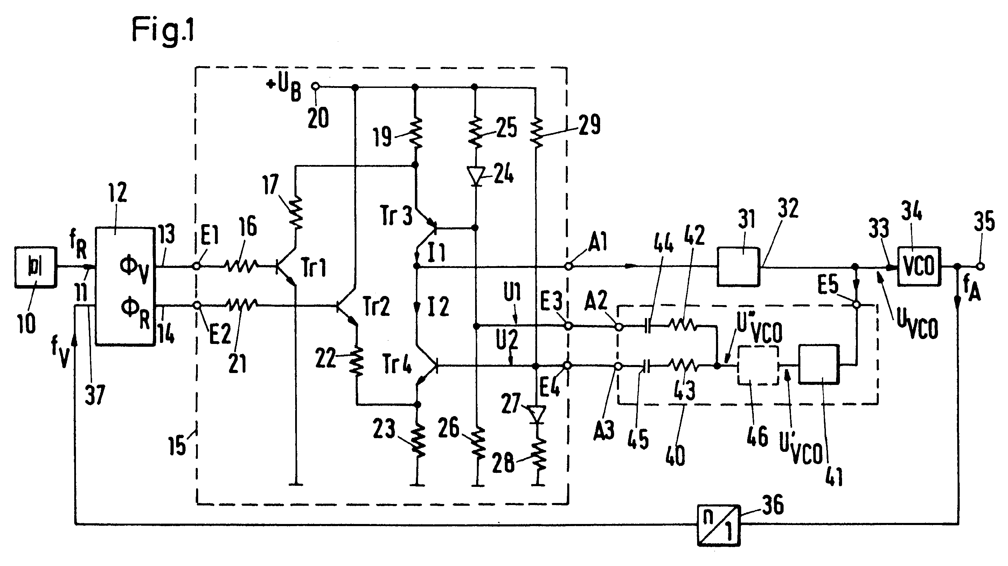

In dem Schaltbild nach Fig. 1 bezeichnet 10 einen Referenzoszillator, der eine vorzugsweise quarzstabilisierte Referenzfrequenz f_{R} an einen ersten Eingang 11 einer Phasenvergleichsschaltung 12 liefert. Ein erster Ausgang 13 und ein zweiter Ausgang 14 der Phasenvergleichsschaltung 12 sind mit je einem Eingang E1 und E2 eines steuerbaren Spannungsimpuls/Stromimpuls-Wandlers 15 verbunden, der dem in Fig. 1 durch gestrichelte Linien umrahmten linken Schaltungsteil entspricht. In dem steuerbaren Spannungsimpuls/Stromimpuls-Wandler 15 ist der Eingang E1 über einen ersten Widerstand 16 mit der Basis eines ersten Transistors Tr1 von npn-Typ verbunden, dessen Emitter mit Masse und dessen Kollektor über einen zweiten Widerstand 17 mit dem Emitter eines dritten Transistors Tr3 vom pnp-Typ sowie über einen dritten Widerstand 19 mit einem Schaltungspunkt 20 positiven Betriebspotentials U_{B} verbunden ist.

Der zweite Eingang E2 des steuerbaren Spannungsimpuls/Stromimpuls-Wandlers 15 ist über einen vierten Widerstand 21 mit der Basis eines zweiten Transistors Tr2 vom npn-Typ verbunden, dessen Kollektor am Schaltungspunkt 20 liegt. Der Emitter des zweiten Transistors Tr2 ist über einen fünften Widerstand 22 mit dem Emitter eines vierten npn-Transistors Tr4 und über einen sechsten Widerstand 23 mit Masse verbunden. Der Kollektor des vierten Transistors Tr4 ist mit dem Kollektor des dritten Transistors Tr3 verbunden. Die Basis des dritten Transistors Tr3 steht über eine erste Diode 24 und einen damit in Reihe liegenden siebenten Widerstand 25 mit dem Schaltungspunkt 20, außerdem unmittelbar mit einem dritten Eingang E3 und über einen achten Widerstand 26 mit Masse in Verbindung. Die Basis des vierten Transistors Tr4 führt unmittelbar an einen vierten Eingang E4 des steuerbaren Spannungsimpuls/Stromimpuls-Wandlers 15, außerdem über eine zweite Diode 27 und einen dazu in Reihe liegenden Widerstand 28 nach Masse und schließlich über einen Widerstand 29 an den Schaltungspunkt 20. Ein Ausgang A1 des steuerbaren Spannungsimpuls/Stromimpuls-Wandlers 15 ist unmittelbar mit den Kollektoren des dritten und vierten Transistors Tr3 und Tr4 verbunden.

An den Ausgang A1 schließt sich ein Schleifenfilter 31 an, dessen Ausgang 32 mit einem Steuereingang 33 eines spannungsgesteuerten Oszillators 34 verbunden ist. Ein Ausgang 35 des spannungsgesteuerten Oszillators 34 ist gleichzeitig der Ausgang der Einschleifen-PLL-Schaltung. Der Ausgang 35 ist über einen einstellbaren Frequenzteiler 36 mit einem zweiten Eingang 37 der Phasenvergleichsschaltung 12 verbunden.

Die vorstehend beschriebene Einschleifen-PLL-Schaltung entspricht einer bekannten Schaltung mit zwei steuerbaren Stromquellen.

Mit 40 ist eine Rückkopplungsschaltung bezeichnet, durch die die bekannte Schaltung ergänzt ist, um eine Einschleifen-PLL-Schaltung mit besonders kurzer Einrastzeit zu erhalten. Die Rückkopplungsschaltung 40 weist einen Eingang E5 und zwei Ausgänge A2 und A3 auf. Der Eingang E5 ist mit dem Ausgang 32 des Schleifenfilters 31 verbunden. Er steht über einen Trennverstärker 41 mit hochohmigem Eingang und zwei parallele Zweige mit je einem Widerstand 42 und 43 und je einem dazu in Reihe liegenden Kondensator 44 und 45 mit je einem der Ausgänge A2 und A3 in Verbindung. An die Ausgänge A2 und A3 schließen sich die Eingänge E3 und E4 der steuerbaren Stromquelle 15 an.

Im folgenden wird zunächst die Wirkungsweise der vorstehend beschriebenen Schaltung nach Fig. 1 ohne Rückkopplungsschaltung 40 beschrieben.

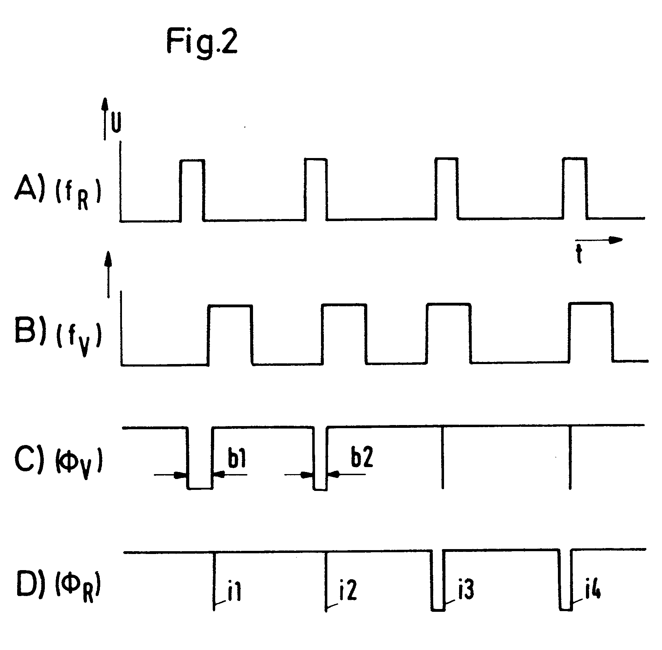

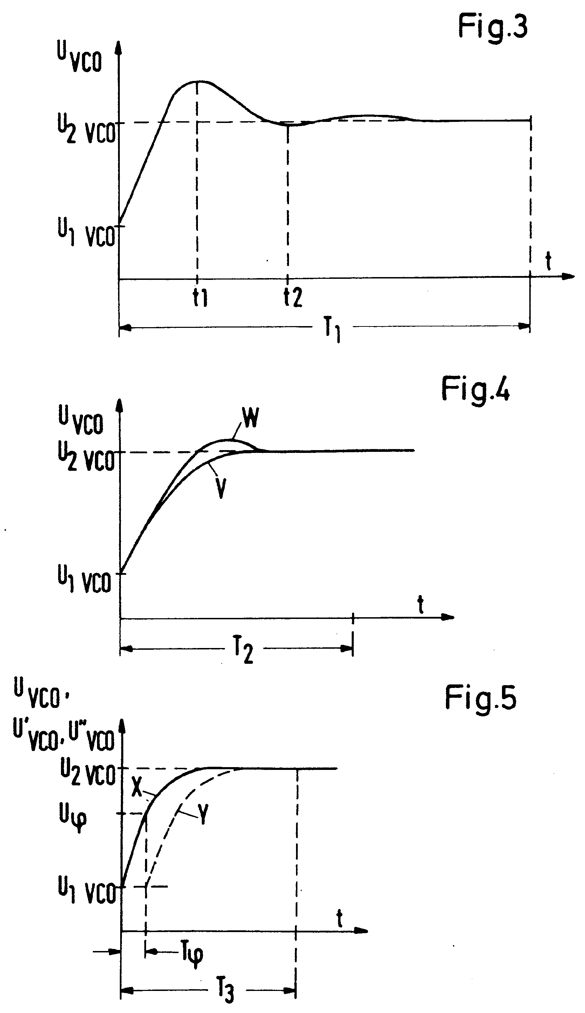

Es wird davon ausgegangen, daß die Einschleifen-PLL-Schaltung mit dem Frequenzteiler 36 auf Ausgangsfrequenzen f_{A} in einem Frequenzbereich von zum Beispiel 890 bis 915 MHz umgeschaltet werden kann. Es wird weiterhin angenommen, daß die Einschleifen-PLL-Schaltung zum Beispiel auf eine erste Frequenz f_{A1} von 890 MHz eingerastet ist. Die Steuerspannung U_{VCO} für den spannungsgesteuerten Oszillator 34 hat dann einen Wert U₁ _{VCO} (Fig. 3), der der ersten Frequenz f_{A1} entspricht. Wird jetzt der Frequenzteiler 36 derart umgeschaltet, daß sich eine zweite Ausgangsfrequenz f_{A2} von zum Beispiel 915 MHz ergeben soll, dann stimmen zunächst die Referenzfrequenz f_{R} von zum Beispiel 200 kHz und die durch Teilung der Ausgangsfrequenz f_{A} erhaltene Vergleichsfrequenz f_{V} in Frequenz und Phase nicht mehr überein. Die Phasenvergleichsschaltung 12 gibt daher an ihrem Ausgang 13 (ΦV) negative Impulse ab (Fig. 2C), deren Impulsbreiten b1, b2 ... von der jeweiligen Frequenz- bzw. Phasenabweichung zwischen der Referenzfrequenz f_{R} und der Vergleichsfrequenz f_{V} abhängen. Der zweite Ausgang 14 (ΦR) liefert zur gleichen Zeit etwa nadelförmige Impulse i1 und i2; vgl. Fig. 2D.

Mit diesen Impulsen wird der steuerbare Spannungsimpuls/Stromimpuls-Wandler 15 angesteuert, und zwar werden über die Widerstände 16 und 21 die Transistoren Tr1 und Tr2 angesteuert, wobei die negativen Impulse am Ausgang 13 der Phasenvergleichsschaltung 12 (vgl. Fig. 2C) den Transistor Tr1 sperren und damit die Stromquelle mit dem Transistor Tr3 einschalten. Diese Stromquelle liefert dann an ihrem Ausgang A1 Stromimpulse I1, die den Spannungsimpulsen in Fig. 2C entsprechen. Aus den Stromimpulsen I1 erzeugt das Schleifenfilter 31 den in Fig. 3 gezeigten, von der Steuerspannung U_{1 VCO} ausgehenden Spannungsverlauf U_{VCO} in Abhängigkeit von der Zeit t. Die Spannung U_{VCO} steuert die Frequenz des spannungsgesteuerten Oszillators 34 in Richtung auf höhere Frequenzen. Nach mehreren Stromimpulsen I1, das heißt zu einem Zeitpunkt t1 (Fig. 3) hat die Steuerspannung U_{VCO} ein Maximum erreicht, das heißt einen Spannungswert, der über der Steuerspannung U_{2 VCO} für die zweite Ausgangsfrequenz f_{A2} liegt. Danach liefert der Ausgang 14 (ΦR) der Phasenvergleichsschaltung 12 Spannungsimpulse i3, i4, die breiter sind als die nadelförmigen Impulse i1, i2. Während der Impulsdauern der Impulse i3, i4 ... wird der zweite Transistor Tr2 gesperrt und die Stromquelle mit dem Transistor Tr4 freigegeben. Sie liefert dann Stromimpulse I2 entgegengesetzter Polarität wie I1 an das Schleifenfilter 31, und zwar solange, bis zu einem Zeitpunkt t2 ein Spannungsminimum erreicht wird usw. Nach Ablauf der Einrastzeit T₁ ist der spannungsgesteuerte Oszillator 34 auf die gewünschte zweite Ausgangsfrequenz f_{A2} = 915 MHz abgestimmt, und die Differenzfrequenz Δf zwischen der Referenzfrequenz f_{R} und der Vergleichsfrequenz f_{V} wird annähernd gleich Null. Damit ist die PLL-Schaltung eingerastet.

Zur Verkürzung der Einrastzeit T₁ der Einschleifen-PLL-Schaltung ist die steuerbare Rückkopplungsschaltung 40 (Fig. 1) erforderlich. In diesem Fall wird an dem Ausgang 32 des Schleifenfilters 31 die Steuerspannung U_{VCO} abgegriffen und dem hochohmigen Eingang des Trennverstärkers 41 zugeführt. Die verstärkte Steuerspannung U′_{VCO} am Ausgang des Trennverstärkers 41 wird über die RC-Glieder 42, 44; 43, 45 den Steuereingängen E3, E4 des steuerbaren Spannungsimpuls/Stromimpuls-Wandlers 15 zugeführt, an denen die Spannungen U1 bzw. U2 liegen. Diese Spannungen werden mittels der RC-Glieder dynamisch durch die Steuerspannung U′_{VCO} beeinflußt, wodurch sich die Stromstärke der Stromimpulse I1 stetig verkleinert; I1 ≈ 1/U1, wobei U₁ auf Masse bezogen ist. Die Dämpfung des Schleifenfilters 31 ist ungefähr 1/I1, das heißt mit kleiner werdender Stromstärke der Stromimpulse I1 wird die Dämpfung größer. Durch empirische Einstellung der Kondensatoren 44, 45 und der Widerstände 42, 43 und/oder der Verstärkung des Trennverstärkers 41 können Kurvenverläufe V, W gemäß Fig. 4 realisiert werden. Der Kurvenverlauf weist dann entweder nur ein geringes Über-schwingen (W) oder kein Überschwingen (V) mehr auf. Auf diese Weise wird die Einrastzeit T₁ auf die Einrastzeit T₂ verkürzt; vgl. Fig. 4.

Eine weitere Verkürzung der Einrastzeit wird erreicht, wenn dem Trennverstärker 41 in Fig. 1 ein Phasenschieber 46 nachgeschaltet wird. Dadurch entsteht während der Einrastzeit T aus der Steuerspannung U′_{VCO} (vgl. Fig. 1 und Kurvenverlauf X in Fig. 5) eine phasenverschobene Spannung U˝_{VCO}; Kurvenverlauf Y in Fig. 5. Durch die Phasenverschiebung setzt die Beeinflussung von U1 bzw. U2 erst nach einer Zeit Tφ ein, so daß die Steuerspannung U_{VCO} bzw. U′_{VCO} bis zum Ablauf dieser Zeit unbeeinflußt bleibt, das heißt während der Zeit Tφ steigt die Kurve X schneller an als die Kurven V bzw. W in Fig. 4. Erst nach Ablauf der Zeit Tφ findet eine Beeinflussung der Spannung U1 bzw. U2 statt. Die Phasenverschiebung wird so gewählt, daß die Beeinflussung etwa nach zwei Dritteln der Differenz zwischen den Spannungen U_{2 VCO} und U_{1 VCO} stattfindet.

## Patentansprüche

1. Einschleifen-PLL-Schaltung mit einem Referenzoszillator (10), einer damit verbundenen Phasenvergleichsschaltung (12), zwei mit der Phasenvergleichsschaltung verbundenen steuerbaren Stromquellen (Tr3, Tr4), einem mit den Stromquellen verbundenen Schleifenfilter (31), einem mit dem Schleifenfilter (31) verbundenen spannungsgesteuerten Oszillator (34) und einem zwischen einem Ausgang des Oszillators (34) und der Phasenvergleichsschaltung (12) liegenden umschaltbaren Frequenzteiler (36), **dadurch gekennzeichnet**, daß ein Trennverstärker (41) mit hochohmigem Eingang und zwei Kondensatoren (44, 45) vorgesehen sind, daß zur Verkürzung der Einrastzeit (T) der PLL-Schaltung beim Umschalten von einer ersten Ausgangsfrequenz (f_{A1}) auf eine zweite Ausgangsfrequenz (f_{A2}) mittels des umschaltbaren Frequenzteilers (36) eine am Ausgang (32) des Schleifenfilters (31) abgegriffene Steuerspannung (U_{VCO}) über den Trennverstärker (41) den Steuereingängen (E3, E4) der steuerbaren Stromquellen (Tr3, Tr4) über je einen der Kondensatoren (44, 45) zugeführt wird.

2. Einschleifen-PLL-Schaltung nach Anspruch 1, dadurch gekennzeichnet, daß mit den Kondensatoren (44, 45) je ein Widerstand (42, 43) in Reihe liegt.

3. Einschleifen-PLL-Schaltung nach Anspruch 1 oder 2, dadurch gekennzeichnet, daß dem Trennverstärker (41) ein Phasenschieber (46) nachgeschaltet ist, dessen Phasenverschiebung so bemessen ist, daß die Beeinflussung der steuerbaren Stromquellen (Tr3, Tr4) erst nach etwa zwei Dritteln des durch die Umschaltung der Ausgangsfrequenz (f_{A}) hervorgerufenen Spannungssprungs (U_{2 VCO} minus U_{1 VCO}) stattfindet.

## Claims

1. Single loop PLL circuit having a reference oscillator (10), a phase comparison circuit (12) connected thereto, two controllable current sources (Tr3, TR4) connected to the phase comparison circuit, a loop filter (31) connected to the current sources, a voltage-controlled oscillator (34) connected to the loop filter (31), and a switchable frequency divider (36) situated between an output of the oscillator (34) and the phase comparison circuit (12), characterized in that provision is made of an isolation amplifier (41) with a high-resistance input and of two capacitors (44, 45), and in that, for the purpose of shortening the latching time (T) of the PLL circuit, on switching over from a first output frequency (f_{A1}) to a second output frequency (f_{A2}) by means of the switchable frequency divider (36) a control voltage (U_{VCO}) tapped at the output (32) of the loop filter (31) is fed via the isolation amplifier (41) to the control inputs (E3, E4) of the controllable current sources (Tr3, Tr4) via in each case one of the capacitors (44, 45).

2. Single loop PLL circuit according to Claim 1, characterized in that in each case a resistor (42, 43) is connected in series with the capacitors (44, 45).

3. Single loop PLL circuit according to Claim 1 or 2, characterized in that connected downstream of the isolation amplifier (41) is a phase shifter (46) whose phase shift is dimensioned such that influencing of the controllable current sources (Tr3, Tr4) does not take place until after approximately two thirds of the voltage jump (U_{2 VCO} minus U_{1 VCO}) caused by switching over the output frequency (f_{A}).

## Revendications

1. Circuit de verrouillage de phase PLL à une boucle comprenant un oscillateur de référence (10), auquel est relié un comparateur de phase (12) avec deux sources de courant (Tr₃, Tr₄) commandées, branchées en comparaison de phase, avec un filtre en boucle (31) relié aux sources de courant, un oscillateur (34) commandé en tension, relié au filtre en boucle (31) et un diviseur de fréquence (36) commutable, branché entre la sortie de l'oscillateur (34) et le circuit de comparaison de phase (12), caractérisé par un amplificateur séparateur (41) à entrée fortement ohmique et deux condensateurs (44, 45) et en ce que pour raccourcir le temps d'accrochage (T) du circuit PLL lors de la commutation d'une première fréquence de sortie (f_{A1}) sur une seconde fréquence de sortie (f_{A2}) à l'aide du diviseur de fréquence commutable (36), une tension de commande (U_{VCO}) prise sur la sortie (32) du filtre en boucle (31) est appliquée par l'intermédiaire de son amplificateur séparateur (41), aux entrées de commande (E3, E4), des sources de courant commandées (Tr3, Tr4) par chaque fois l'un des condensateurs (44, 45).

2. Circuit PLL à une boucle selon la revendication 1, caractérisé en ce qu'une résistance (42, 43) est chaque fois en série sur les condensateurs (44, 45).

3. Circuit PLL à une boucle selon la revendication 1 ou 2, caractérisé en ce qu'un déphaseur (46) est prévu en aval de l'amplificateur séparateur (41), et dont le déphasage est mesuré de telle sorte que l'influence des sources de courant commandées (Tr3, Tr4) ne se produise sensiblement qu'après deux tiers du saut de tension (U_{2 VCO} moins U_{1 VCO}) provoqué par la commutation de la fréquence de sortie (f_{A}).
